(19) Europäisches Patentamt / European Patent Office / Office européen des brevets

(11) **EP 3 614 446 B1**

(12) **FASCICULE DE BREVET EUROPEEN**

(45) Date de publication et mention de la délivrance du brevet:
**15.09.2021 Bulletin 2021/37**

(51) Int Cl.:
***H01L 45/00*** *(2006.01)*

(21) Numéro de dépôt: **19188116.8**

(22) Date de dépôt: **24.07.2019**

(54) **ELÉMENT DE MÉMORISATION**

SPEICHERELEMENT

MEMORY STORAGE ELEMENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.08.2018 FR 1857391**

(43) Date de publication de la demande:
**26.02.2020 Bulletin 2020/09**

(73) Titulaire: **Commissariat à l'Energie Atomique et aux Energies Alternatives
75015 Paris (FR)**

(72) Inventeurs:
• **NAVARRO, Gabriele
38054 Grenoble Cedex 9 (FR)**
• **BERNARD, Mathieu
38054 Grenoble Cedex 9 (FR)**
• **CYRILLE, Marie-Claire
38054 Grenoble Cedex 9 (FR)**
• **SABBIONE, Chiara
38054 Grenoble Cedex 9 (FR)**

(74) Mandataire: **Cabinet Beaumont
4, Place Robert Schuman
B.P. 1529
38025 Grenoble Cedex 1 (FR)**

(56) Documents cités:
CN-A- 105 870 323      US-A1- 2009 237 983
US-A1- 2010 096 609      US-A1- 2017 263 863

• HU YIFENG ET AL: "Ge2Sb2Te5/Sb superlattice-like thin film for high speed phase change memory application", APPLIED PHYSICS LETTERS, A I P PUBLISHING LLC, US, vol. 107, no. 26, 28 décembre 2015 (2015-12-28), XP012204196, ISSN: 0003-6951, DOI: 10.1063/1.4939149 [extrait le 1901-01-01]
• Y HU ET AL: "Superlattice-like Ge8Sb92/Ge thin films for high speed and low power consumption phase change memory application", SCRIPTA MATERIALIA., vol. 93, 22 septembre 2014 (2014-09-22), pages 4-7, XP055658442, NL ISSN: 1359-6462, DOI: 10.1016/j.scriptamat.2014.08.009

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

Domaine technique

La présente description concerne de façon générale les éléments de mémorisation et plus particulièrement les éléments de mémorisation à changement de phase.

Technique antérieure

Les matériaux à changement de phase sont des matériaux qui peuvent basculer, sous l'effet de la chaleur, entre une phase cristalline et une phase amorphe. Comme la résistance électrique d'un matériau amorphe est significativement supérieure à la résistance électrique d'un matériau cristallin, ce phénomène peut être utile pour définir deux états de mémoire, par exemple 0 et 1, différenciés par la résistance mesurée à travers le matériau à changement de phase.

La diminution des dimensions des éléments de mémorisation à changement de phase, et plus particulièrement la diminution de l'épaisseur de la couche de matériau à changement de phase et du volume de matériau à changement de phase peut entrainer une augmentation de la température de cristallisation et une augmentation de la stabilité thermique du matériau dans la phase amorphe.

Les matériaux à changement de phase les plus communs dans les éléments de mémorisation sont les alliages à base de germanium, d'antimoine et de tellure. Ces alliages sont généralement en proportions stoechiométriques. Des alliages ayant des proportions non stoechiometriques peuvent être préférés à des alliages ayant des proportions stoechiométriques car ils peuvent avoir des caractéristiques souhaitées, par exemple une température de cristallisation plus élevée. Cependant, la fabrication d'éléments de mémorisation comprenant de tels alliages a divers inconvénients. Notamment, la cristallisation de tels alliages et/ou la séparation de phase peut entrainer une non homogénéité de l'alliage, ce qui peut entrainer une baisse du rendement. Un exemple de l'art antérieur se trouve dans Hu Yifeng et. al., "Ge2Sb2Te5/Sb superlattice-like thin film for high speed phase change memory application", Applied Physics Letters, Vol. 107, Nr. 26.

Résumé de l'invention

Un mode de réalisation pallie tout ou partie des inconvénients des éléments de mémorisation connus.

Un mode de réalisation prévoit un élément de mémorisation à changement de phase comprenant, dans une première portion, un empilement de couches amorphes, l'épaisseur de chaque couche de l'empilement étant inférieure ou égale à 5 nm. L'élément comprend une deuxième portion traversant au moins certaines couches de l'empilement, en un alliage d'au moins une partie des composants des couches de l'empilement.

Selon un mode de réalisation, l'empilement comprend au moins deux ensembles de couches en des matériaux différents.

Selon un mode de réalisation, les couches de l'empilement sont en un élément chimique, ou un alliage d'éléments chimiques, des groupes 13, 14, 15 et 16 du tableau périodique des éléments.

Selon un mode de réalisation, l'empilement comprend une alternance de premières et de deuxièmes couches, les premières et deuxièmes couches étant en des matériaux différents.

Selon un mode de réalisation, les premières couches sont en un alliage à base de germanium, d'antimoine et de tellure, et les deuxièmes couches sont en antimoine ou en germanium.

Selon un mode de réalisation, le matériau de chaque couche de l'empilement a des proportions stoechiométriques.

Selon un mode de réalisation, les proportions du matériau de la deuxième portion ne sont pas stoechiométriques.

Selon un mode de réalisation, les première et deuxième portions sont séparées par une peau en un matériau d'une des couches de l'empilement.

Selon un mode de réalisation, l'élément comprend un élément résistif en contact avec la deuxième portion.

Selon un mode de réalisation, le matériau de la deuxième portion est un matériau à changement de phase.

Selon un mode de réalisation, des couches d'un ensemble de couches de l'empilement sont dopées.

Selon un mode de réalisation, les couches de l'ensemble de couches sont dopées avec un ou plusieurs dopants parmi l'azote, le carbone et le silicium.

Selon un mode de réalisation, le dopage des couches de l'ensemble de couches est graduel.

Un mode de réalisation prévoit une cellule mémoire à changement de phase comprenant un élément de mémorisation tel que décrit précédemment.

Un mode de réalisation prévoit un procédé de fabrication d'un élément de mémorisation comprenant la formation d'un empilement de couches amorphes, l'épaisseur de chaque couche étant inférieure ou égale à 5 nm.

Selon un mode de réalisation, le procédé comprend une étape de chauffe d'une portion de l'empilement, de manière à ce que cette portion comprenne un alliage d'au moins une partie des composants des couches de l'empilement.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1 est une vue en coupe schématique et partielle d'un mode de réalisation d'un élément de mémorisation ;

la figure 2 représente schématiquement et partiellement des structures obtenues au cours de la fabrication de l'élément de mémorisation de la figure 1 ;

la figure 3 représente la résistivité de deux matériaux à changement de phase en fonction de la température ; et

la figure 4 est une vue en coupe schématique et partielle d'un autre mode de réalisation d'un élément de mémorisation.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les cellules mémoire comprennent des éléments, par exemple des éléments de sélection, par exemple des transistors ou des connexions électriques, qui ne seront pas détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence, sauf précision contraire, à l'orientation des figures.

Sauf précision contraire, les expressions "environ", "approximativement", "sensiblement", et "de l'ordre de" signifient à 10 % près, de préférence à 5 % près.

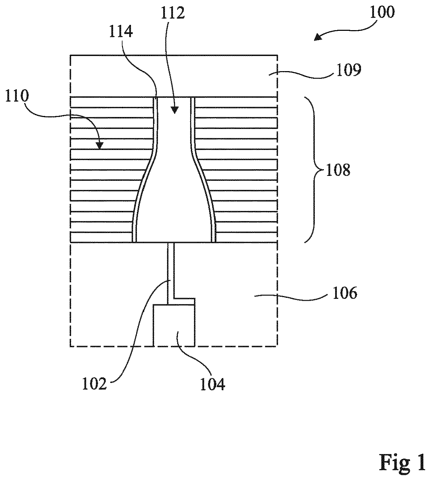

La figure 1 est une vue en coupe, schématique et partielle, d'un mode de réalisation d'un élément de mémorisation 100. L'élément de mémorisation 100 est par exemple compris dans une cellule mémoire à changement de phase.

L'élément de mémorisation 100 comprend un élément résistif 102 connecté à un élément de sélection, par exemple un transistor, non représenté, par l'intermédiaire d'un via conducteur 104. L'élément résistif 102 a par exemple une section en forme de L dont la partie horizontale est en contact avec le via conducteur 104. L'élément résistif 102 et le via conducteur 104 sont entourés d'une couche isolante 106. L'épaisseur de la couche 106 est telle que la face supérieure de la partie verticale de l'élément résistif est coplanaire avec la face supérieure de la couche isolante 106. L'élément de sélection est situé sous la couche 106.

L'élément de mémorisation 100 comprend, de plus, une région 108 reposant sur la face supérieure de la couche isolante 106 et sur la face supérieure de la partie verticale de l'élément résistif 102. Une couche conductrice 109 repose sur la région 108. La couche conductrice 109 forme une électrode de l'élément de mémorisation.

La région 108 comprend une première portion 110 et une deuxième portion 112.

La première portion 110 comprend un empilement de couches, de préférence toutes en matériaux amorphes. Les couches de l'empilement sont de préférence en des éléments chimiques, ou des alliages d'éléments chimiques, des groupes 13, 14, 15 ou 16 du tableau périodique des éléments. Le groupe 13 comprend le bore, l'aluminium, le gallium, l'indium et le thallium. Le groupe 14 comprend le carbone, le silicium, le germanium, l'étain, le plomb, et le flérovium. Le groupe 15 comprend le phosphore, l'arsenic, l'antimoine, le bismuth, et le moscovium. Le groupe 16 comprend le soufre, le sélénium, le tellure, le polonium et le livermorium.

Chaque couche de l'empilement 110 est en un matériau ayant de préférence des proportions stoechiométriques. Ces matériaux sont par exemple des matériaux choisis dans la liste suivante : $Ge_2Sb_2Te_5$, $GeTe$, $Ge$, $Te$, $Sb$, $Sb_2Te_3$, $Bi_2Te_3$, $GeSe$, $GeS_2$.

L'empilement 110 comprend par exemple alternativement des premières et des deuxièmes couches, les premières et deuxièmes couches étant en des matériaux différents.

Les premières couches sont, par exemple, en un alliage à base de germanium, d'antimoine et de tellure (GST), par exemple le $Ge_2Sb_2Te_5$, et les deuxièmes couches sont par exemple en antimoine ou en germanium. Par exemple, les deuxièmes couches sont en un matériau n'étant pas un matériau à changement de phase.

Chacune des couches de l'empilement 110 a une épaisseur inférieure ou égale à environ 5 nm, par exemple comprise entre la constante atomique du matériau de la couche et environ 5 nm, de préférence comprise entre 2 et 5 nm. De préférence, chacune des couches de l'empilement 110 a une épaisseur strictement inférieure à environ 5 nm, de préférence strictement inférieure à 5 nm.

Par exemple, si l'empilement comprend un même nombre de couches A et B en des matériaux différents, les épaisseurs des couches A et B sont déterminées dans la gamme précédemment évoquée en résolvant les équations suivantes :

[Math 1]

$$T = N \times (t_A + t_B)$$

[Math 2]

$$P_A = 100 \times \frac{t_A}{t_A + t_B}$$

[Math 3]

$$P_B = 100 \times \frac{t_B}{t_A + t_B}$$

où T est l'épaisseur totale de l'empilement 110, $t_A$ est l'épaisseur d'une couche A, $t_B$ est l'épaisseur d'une couche B, N est le nombre de couches A (égal au nombre de couches B), $P_A$ est la proportion (en %) du matériau des couches A dans l'ensemble de l'empilement, $P_B$ est la proportion (en %) du matériau des couches B dans l'ensemble de l'empilement.

De manière plus générale, l'empilement comprend au moins deux ensembles de couches, chaque ensemble comprenant des couches étant en un matériau différent des matériaux des couches des autres ensembles.

Les première et deuxième portions 110 et 112 peuvent être séparées par une peau 114 en un des éléments chimiques de l'empilement 110. Par exemple, si l'empilement 110 comprend des couches de GST et d'antimoine, la peau 114 peut être en antimoine.

La deuxième portion 112, résultant par exemple de la fusion de couches de l'empilement 110 comme cela sera décrit par la suite, est en contact avec la face supérieure de la couche 106 et la face supérieure de la partie verticale de l'élément résistif 102.

Dans l'exemple de la figure 1, la deuxième portion s'étend par exemple de la face supérieure de la couche isolante 106 à la couche conductrice 109. De manière plus générale, la deuxième partie traverse au moins certaines couches de l'empilement 110.

La deuxième portion 112 est en un alliage d'au moins certains des éléments chimiques et/ou alliages d'éléments chimiques, des couches de l'empilement 110. La deuxième portion 112 est en un matériau à changement de phase. La deuxième portion 112 est de préférence en un matériau ayant des proportions non stoechiométriques. La deuxième portion 112 est par exemple en un alliage de germanium, d'antimoine et de tellure ayant une concentration en germanium ou en antimoine supérieure à celle des alliages ayant des proportions stoechiométriques.

L'information écrite, ou programmée, dans l'élément de mémorisation est déterminée par l'état amorphe ou cristallin d'au moins une partie de la deuxième portion 112.

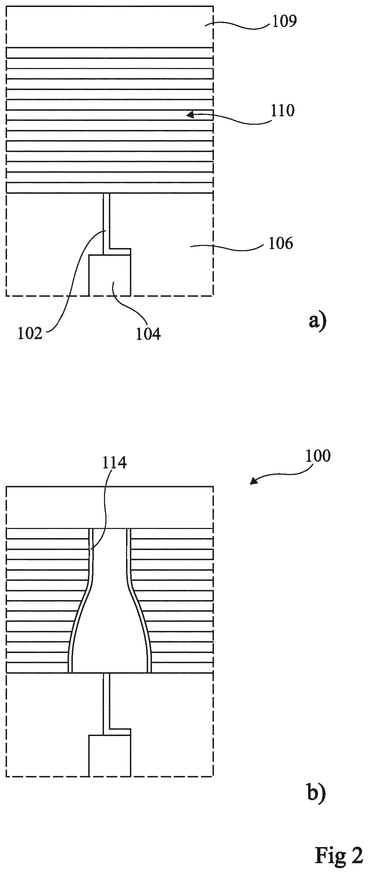

La figure 2 représente schématiquement et partiellement deux structures a) et b) obtenues après deux étapes de fabrication du mode de réalisation de la figure 1.

La structure a) est obtenue après des étapes comprenant :

- la formation de l'élément de sélection non représenté ;

- la formation de la couche isolante 106 ;

- la formation du via conducteur 104 ;

- la formation de l'élément résistif 102 ;

- la formation de l'empilement 110 sur la face supérieure de la couche isolante 106 et sur la face supérieure de la partie verticale de l'élément résistif 102. L'empilement 110 peut comprendre un nombre quelconque de couches, chaque couche ayant une épaisseur inférieure ou égale à 5 nm, par exemple comprise entre la constante atomique du matériau de la couche et environ 5 nm ; et

- la formation de la couche conductrice 109, recouvrant la couche supérieure de l'empilement 110.

Les couches de l'empilement sont par exemple formée une par une par dépôt physique en phase vapeur (PVD - Physical Vapor Deposition).

La structure b) est obtenue en chauffant l'élément résistif 102 par un courant se déplaçant entre le via conducteur 104 et la couche conductrice 109. La température de l'élément résistif 102 devient alors suffisante pour que l'empilement 110 passe par une étape d'initialisation au cours de laquelle la deuxième portion 112 est formée en le deuxième alliage à partir des parties des couches de l'empilement chauffées. La peau 114 peut se former à cette étape.

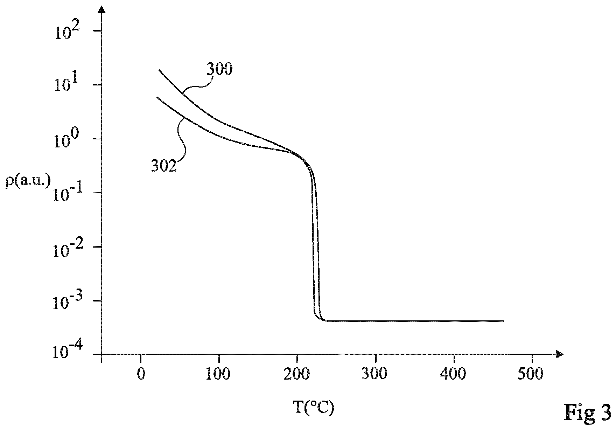

La figure 3 représente la résistivité (p(a.u.)) de deux matériaux à changement de phase en fonction de la température (T(°C)).

Une courbe 300 correspond à la résistivité d'un bloc massif (bulk) d'un alliage à base de germanium, d'antimoine et de tellure ayant une concentration en antimoine supérieure à celle d'un alliage ayant des proportions stoechiométriques.

Une courbe 302 correspond à un empilement de couches amorphes tel que celui décrit dans la figure 1, comprenant des couches d'un alliage de germanium, d'antimoine et de tellure ayant des proportions stoechiométriques et des couches d'antimoine. L'empilement comprend la même quantité de germanium, d'antimoine et de tellure que le bloc massif associé à la courbe 300.

On remarque que les courbes 300 et 302 sont similaires. Ainsi, le bloc massif et l'empilement de couches ont des comportements similaires lorsque la température à laquelle ils sont soumis augmente. En particulier, la température à laquelle on peut observer une variation importante et rapide (à environ 220°C) et qui correspond à la température de cristallisation, est similaire pour le bloc massif et l'empilement de couches.

De manière plus générale, des expériences ont montré que, d'un point de vue macroscopique, c'est-à-dire en considérant l'empilement entier comme étant un unique élément, l'empilement de couches a un comportement similaire au bloc massif.

Cependant, les composants d'un bloc massif d'un alliage n'ayant pas de proportions stoechiométriques ont tendance à se recomposer en éléments stoechiométriques, aussi appelée séparation de phases, particulièrement lorsqu'ils sont soumis aux températures relativement élevées des procédés de fabrication. Cette recomposition entraine une variabilité entre des éléments de mémorisation autrement sensiblement identiques. Les modes de réalisation décrits, comprenant déjà des couches ayant des proportions stoechiométriques, sont moins sujettes à de telles recompositions.

Des résultats similaires sont observés pour des empilements comprenant des couches de matériaux appartenant aux groupes 14, 15 et 16 précédemment évoqués.

De tels résultats ne peuvent être observés pour des empilements de couches ayant des épaisseurs supérieures à 5 nm. En effet, au niveau des interfaces entre deux couches, les éléments chimiques des deux couches forment des connexions, éventuellement des alliages, de la même manière que si les différents éléments chimiques étaient réunis dans un bloc massif. Les épaisseurs considérées des couches des empilements des modes de réalisation décrits permettent qu'une partie suffisante de chaque couche soit sujette à ce phénomène pour que, d'un point de vue macroscopique, l'empilement se comporte sensiblement comme un bloc massif.

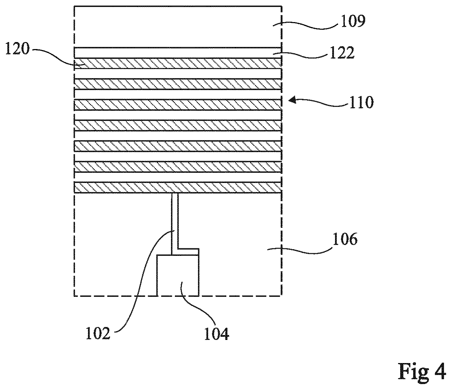

La figure 4 est une vue en coupe schématique et partielle d'un autre mode de réalisation d'un élément de mémorisation. Plus précisément, la figure 4 représente une structure à un même stade de fabrication que la structure a) de la figure 2. La structure de la figure 4 comprend tous les éléments de la figure 2.

L'empilement 110 du mode de réalisation de la figure 4 comprend des couches 120 et 122. Les couches 120 (couches hachurées) sont dopées et les couches 122 ne sont pas dopées. Le dopage des couches 120 est effectué de préférence couche par couche lors de la formation de l'empilement. Cela permet de contrôler précisément le dopage dans l'empilement.

Les couches 120 sont par exemple dopées avec un ou plusieurs dopants parmi l'azote, le carbone et le silicium.

Les couches 120 sont par exemple des couches en un germanium dopé avec de l'azote et les couches 122 sont par exemple un alliage à base de germanium, d'antimoine et de tellure. Dans cet exemple, les couches 120 sont dopées de manière sensiblement identique.

A titre de variante, l'empilement peut comprendre plusieurs ensembles de couches en des matériaux différents, chaque ensemble pouvant être ou non dopé. Par exemple, la partie haute de l'empilement 110 peut être dopée avec du carbone, de manière à réduire le risque d'inter diffusion entre le matériau de la couche 109 et le matériau de la couche supérieure de l'empilement 110, et la partie basse peut être dopée avec de l'azote de manière à augmenter la température de cristallisation.

Un tel dopage couche par couche a pour avantage de permettre l'interaction des dopants avec certains éléments de l'empilement mais pas avec tous, tout en conservant un empilement dont le comportement macroscopique est uniforme.

A titre de variante, l'empilement peut comprendre au moins un ensemble de couches dont le dopage est graduel. Par exemple, le dopage peut augmenter entre la couche dudit ensemble la plus proche de la couche inférieure de l'empilement et la couche dudit ensemble la plus proche de la couche supérieure de l'empilement.

Un tel dopage graduel a pour avantage de permettre, par exemple, la modulation de la résistivité du matériau à changement de phase sur sa hauteur.

Un avantage des modes de réalisation décrits est que les types de dopage décrits en relation avec la figure 4 ne peuvent pas être obtenus par co-pulvérisation avec une technique de dépôt standard ou par implantation ionique.

Un avantage des modes de réalisation décrits est que le procédé de fabrication n'ajoute pas de variabilité entre différents éléments de mémorisation formés simultanément. Les éléments de mémorisation d'un même dispositif mémoire peuvent donc être dans un même état à l'initialisation, ce qui permet une augmentation du rendement de la mémoire.

Un autre avantage des modes de réalisation décrits est que les couches amorphes de la première portion 110 forment un isolant thermique. En effet, les éléments chimiques dans leur état amorphe conduisent moins bien la chaleur que dans leur état cristallin. Cela permet ainsi de limiter, lors de l'écriture d'une telle cellule mémoire, la perte de chaleur, et donc d'énergie, hors de la deuxième portion.

Un autre avantage des modes de réalisation décrits est que les couches amorphes de la première portion 110 rendent la portion 112 moins sujette au phénomène de recristallisation qui pourrait entrainer une perte de la donnée mémorisée.

Un autre avantage des modes de réalisation décrits est que, dans un cas où les températures du procédé de fabrication entrainent une séparation de phases ou une recristallisation des couches de l'empilement, la taille des cristaux est plus homogène que dans le cas d'un bloc massif, et permet donc de mieux maitriser la dynamique de la cristallisation.

Divers modes de réalisation et variantes ont été décrits. L'homme de l'art comprendra que certaines caractéristiques de ces divers modes de réalisation et variantes pourraient être combinées, et d'autres variantes apparaitront à l'homme de l'art.

Enfin, la mise en oeuvre pratique des modes de réalisation et variantes décrits est à la portée de l'homme du métier à partir des indications fonctionnelles données ci-dessus.

## Revendications

1. Elément de mémorisation à changement de phase (100) comprenant, dans une première portion (110), un empilement (110) de couches amorphes, l'épaisseur de chaque couche de l'empilement étant inférieure ou égale à 5 nm, l'élément comprenant une deuxième portion (112) traversant au moins certaines couches de l'empilement (110), en un alliage d'au moins une partie des composants des couches de l'empilement (110) .

2. Elément selon la revendication 1, dans lequel l'empilement (110) comprend au moins deux ensembles de couches en des matériaux différents.

3. Elément selon la revendication 1 ou 2, dans lequel les couches de l'empilement (110) sont en un élément chimique, ou un alliage d'éléments chimiques, des groupes 13, 14, 15 et 16 du tableau périodique des éléments.

4. Elément selon l'une quelconque des revendications 1 à 3, dans lequel l'empilement (110) comprend une alternance de premières et de deuxièmes couches, les premières et deuxièmes couches étant en des matériaux différents.

5. Elément selon la revendication 4, dans lequel les premières couches sont en un alliage à base de germanium, d'antimoine et de tellure, et les deuxièmes couches sont en antimoine ou en germanium.

6. Elément selon l'une quelconque des revendications 1 à 5, dans lequel le matériau de chaque couche de l'empilement (110) a des proportions stoechiométriques.

7. Elément selon l'une quelconque des revendications 1 à 6, dans lequel les proportions du matériau de la deuxième portion (112) ne sont pas stoechiométriques.

8. Elément selon l'une quelconque des revendications 1 à 7, dans lequel les première (110) et deuxième (112) portions sont séparées par une peau (114) en un matériau d'une des couches de l'empilement.

9. Elément selon l'une quelconque des revendications 1 à 8, comprenant un élément résistif (102) en contact avec la deuxième portion (112).

10. Elément selon l'une quelconque des revendications 1 à 9, dans lequel le matériau de la deuxième portion (112) est un matériau à changement de phase.

11. Elément selon l'une quelconque des revendications 1 à 10, dans lequel des couches (120) d'un ensemble de couches de l'empilement (110) sont dopées.

12. Elément selon la revendication 11, dans lequel les couches de l'ensemble de couches (120) sont dopées avec un ou plusieurs dopants parmi l'azote, le carbone et le silicium.

13. Elément selon la revendication 11 ou 12, dans lequel le dopage des couches de l'ensemble de couches est graduel.

14. Cellule mémoire à changement de phase comprenant un élément de mémorisation (100) selon l'une quelconque des revendications 1 à 13.

15. Procédé de fabrication d'un élément de mémorisation (100) comprenant la formation d'un empilement (110) de couches amorphes, l'épaisseur de chaque couche étant inférieure ou égale à 5 nm, l'élément comprenant une deuxième portion (112) traversant au moins certaines couches de l'empilement (110), en un alliage d'au moins une partie des composants des couches de l'empilement (110).

16. Procédé selon la revendication 15, comprenant une étape de chauffe d'une portion (112) de l'empilement, de manière à ce que cette portion comprenne un alliage d'au moins une partie des composants des couches de l'empilement (110).

## Patentansprüche

1. Phasenwechsel-Speicherelement (100), das in einem ersten Abschnitt (110) einen Stapel (110) aus amorphen Schichten aufweist, wobei die Dicke jeder Schicht in dem Stapel kleiner oder gleich 5 nm ist, wobei das Element einen zweiten Abschnitt (112) umfasst, der wenigstens bestimmte Schichten in dem Stapel (110) kreuzt und aus einer Legierung aus wenigstens einem Teil der Komponenten der Schichten in dem Stapel (110) besteht.

**2.** Element nach Anspruch 1, wobei der Stapel (110) wenigstens zwei Anordnungen von Schichten aus unterschiedlichen Materialien aufweist.

**3.** Element nach Anspruch 1 oder 2, wobei die Schichten im Stapel (110) aus einem chemischen Element oder aus einer Legierung chemischer Elemente der Gruppen 13, 14, 15 und 16 des Periodensystems der Elemente hergestellt sind.

**4.** Element nach einem der Ansprüche 1 bis 3, wobei der Stapel (110) einen Wechsel von ersten und zweiten Schichten aufweist, wobei die ersten und zweiten Schichten aus unterschiedlichen Materialien bestehen.

**5.** Element nach Anspruch 4, wobei die ersten Schichten aus einer Legierung aus Germanium, Antimon und Tellur bestehen und die zweiten Schichten aus Antimon oder Germanium bestehen.

**6.** Element nach einem der Ansprüche 1 bis 5, wobei das Material jeder Schicht in dem Stapel (110) stöchiometrische Anteile aufweist.

**7.** Element nach einem der Ansprüche 1 bis 6, wobei die Anteile des Materials des zweiten Teils (112) nicht stöchiometrisch sind.

**8.** Element nach einem der Ansprüche 1 bis 7, wobei der erste (110) und der zweite (112) Abschnitt durch eine Haut (114) getrennt sind, die aus einem Material einer der Schichten im Stapel besteht.

**9.** Element nach einem der Ansprüche 1 bis 8, das ein Widerstandselement (102) in Kontakt mit dem zweiten Abschnitt (112) aufweist.

**10.** Element nach einem der Ansprüche 1 bis 9, wobei das Material des zweiten Abschnitts (112) ein Phasenwechselmaterial ist.

**11.** Element nach einem der Ansprüche 1 bis 10, wobei Schichten (120) einer Anordnung von Schichten des Stapels (110) dotiert sind.

**12.** Element nach Anspruch 11, wobei die Schichten der Anordnung von Schichten (120) mit einem oder mehreren Dotierstoffen aus Stickstoff, Kohlenstoff und Silizium dotiert sind.

**13.** Element nach Anspruch 11 oder 12, wobei die Dotierung der Schichten der Schichtanordnung graduell erfolgt.

**14.** Phasenwechsel-Speicherzelle mit dem Speicherelement (100) nach einem der Ansprüche 1 bis 13.

**15.** Verfahren zur Herstellung eines Speicherelements (100), aufweisend Ausbilden eines Stapels (110) aus amorphen Schichten, wobei die Dicke jeder Schicht kleiner oder gleich 5 nm ist, wobei das Element einen zweiten Abschnitt (112) aufweist, der mindestens bestimmte Schichten in dem Stapel (110) kreuzt und aus einer Legierung aus mindestens einem Teil der Komponenten der Schichten in dem Stapel (110) besteht.

**16.** Verfahren nach Anspruch 15, aufweisend einen Schritt des Erhitzens eines Abschnitts (112) des Stapels, so dass der Abschnitt eine Legierung aus mindestens einem Teil der Komponenten der Schichten im Stapel (110) aufweist.

**Claims**

**1.** A phase-change storage element (100) comprising, in a first portion (110), a stack (110) of amorphous layers, the thickness of each layer in the stack being smaller than or equal to 5 nm, the element comprising a second portion (112) crossing at least certain layers in the stack (110), made of an alloy of at least a portion of the components of the layers in the stack (110).

**2.** The element of claim 1, wherein the stack (110) comprises at least two assemblies of layers made of different materials.

**3.** The element of claim 1 or 2, wherein the layers in the stack (110) are made of a chemical element or of an alloy of chemical elements from groups 13, 14, 15, and 16 of the periodic table of elements.

**4.** The element of any of claims 1 to 3, wherein the stack (110) comprises an alternation of first and of second layers, the first and second layers being made of different materials.

**5.** The element of claim 4, wherein the first layers are made of an alloy made up of germanium, antimony, and tellurium, and the second layers are made of antimony or of germanium.

**6.** The element of any of claims 1 to 5, wherein the material of each layer in the stack (110) has stoichiometric proportions.

**7.** The element of any of claims 1 to 6, wherein the proportions of the material of the second portion (112) are not stoichiometric.

**8.** The element of any of claims 1 to 7, wherein the first (110) and second (112) portions are separated by a skin (114) made of a material of one of the layers in the stack.

9. The element of any of claims 1 to 8, comprising a resistive element (102) in contact with the second portion (112).

10. The element of any of claims 1 to 9, wherein the material of the second portion (112) is a phase-change material.

11. The element of any of claims 1 to 10, wherein layers (120) of an assembly of layers of the stack (110) are doped.

12. The element of claim 11, wherein the layers of the assembly of layers (120) are doped with one or a plurality of dopants among nitrogen, carbon, and silicon.

13. The element of claim 11 or 12, wherein the doping of the layers of the layer assembly is gradual.

14. A phase-change memory cell comprising the storage element (100) of any of claims 1 to 13.

15. A method of manufacturing a storage element (100) comprising forming a stack (110) of amorphous layers, the thickness of each layer being smaller than or equal to 5 nm, the element comprising a second portion (112) crossing at least certain layers in the stack (110), made of an alloy of at least part of the components of the layers in the stack (110).

16. The method of claim 15, comprising a step of heating a portion (112) of the stack, so that the portion comprises an alloy of at least part of the components of the layers in the stack (110).

Fig 1

a)

b)

Fig 2

Fig 3

Fig 4

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **YIFENG.** Ge2Sb2Te5/Sb superlattice-like thin film for high speed phase change memory application. *Applied Physics Letters,* vol. 107 (26